# EUROPEAN PATENT APPLICATION

(11) **EP 4 369 364 A1**
(43) Date of publication of application: **15.05.2024**
(21) Application number: 23209485.4
(22) Date of filing: 13.11.2023
(51) Int. Cl.: H01F 27/28, H01F 27/40

(54) **PLANAR MAGNETIC COMPONENT**

(30) Priority: 14.11.2022 US 202263425014 P
(71) Applicant: Delta Electronics Inc., Taoyuan City 320023 (TW)
(72) Inventor: CHANG, Yi-Sheng, 320023 Taoyuan City (TW); LAI, Chien-An, 320023 Taoyuan City (TW); CHIU, Yi-Hsun, 320023 Taoyuan City (TW); YANG, Chun-Yu, 320023 Taoyuan City (TW)
(74) Representative: 2K Patentanwälte Blasberg Kewitz & Reichel

(57) **Abstract**

A planar magnetic component (PE) is arranged on a circuit board (CB1) of a resonant converter (100), and the resonant converter (100) includes a primary-side circuit (1A) and a secondary-side circuit (3A). The planar magnetic component (PE) includes an inductor trace (Tl), a primary-side trace (Tp1), a secondary-side trace (Ts1), and an iron core assembly. The iron core assembly includes an inductor iron core (C_L) and an iron core (C1). The primary-side trace (Tp1) surrounds the first through hole (H1) in a first direction (D1) and surrounds the second through hole (H2) in a second direction (D2) to form an oo-shaped trace. The inductor trace (TI) is formed on the primary-side layer board and coupled to the primary-side trace (Tp1), and two ends of the inductor trace (TI) form an input terminal and an output terminal of the planar magnetic component (PE).

## Description

### BACKGROUND

### Technical Field

The present disclosure relates to a planar magnetic component, and more particularly to a planar magnetic component applied to an isolated converter.

### Description of Related Art

The statements in this section merely provide background information related to the present disclosure and do not necessarily constitute prior art.

With the rapid development of the information industry, power supplies have played an indispensable role. The input voltage of information and household appliances is divided into AC voltage and DC voltage, and power supplies can generally be divided into two levels. In general, the front stage is usually an AC-to-DC converter, a power factor corrector or a DC-to-DC converter, and the rear stage is usually a resonant converter. The resonant converter is a DC-to-DC power converter, and it has a primary-side switch that turns on at zero voltage and a secondary-side rectification switch that turns off at zero current. Therefore, it has the advantages of high power and high conversion efficiency than other converters. Furthermore, using a rectification switch on the secondary side makes it easier to achieve high efficiency and high power density.

In particular, resonant converters usually include inductive components such as resonant inductors and transformers, and these inductive components are usually composed of coils, bobbins, and iron cores. Since the coil must be formed by winding copper wire on the winding frame for more than dozens of turns, and then the iron core is used to set the winding to form a closed magnetic circuit, resonant inductors and transformers usually have the fatal disadvantage of being bulky. Therefore, the size of the resonant converter cannot be effectively reduced, resulting in the problem of bulky power supply and poor power density.

Therefore, how to design a planar magnetic component to replace the traditional magnetic component in the resonant converter to greatly reduce the size of the resonant converter has become a critical topic in this field.

### SUMMARY

In order to solve the above-mentioned problems, the present disclosure provides a planar magnetic component. The planar magnetic component is arranged on a circuit board of a resonant converter, and the resonant converter includes a primary-side circuit and a secondary-side circuit. The planar magnetic component includes an inductor trace, a primary-side trace, a secondary-side trace, and an iron core assembly. The inductor trace is arranged on the circuit board to serve as an inductor coil coupled to the primary-side circuit. The primary-side trace is formed on one primary-side layer board of the circuit board to serve as a primary-side coil coupled to the primary-side circuit. The secondary-side trace is formed on one secondary-side layer board of the circuit board to serve as a secondary-side coil coupled to the secondary-side circuit. The iron core assembly includes an inductor iron core and an iron core. The inductor iron core includes a core pillar, and the core pillar penetrates a third through hole of the circuit board and the inductor trace surrounds the third through hole. The iron core includes a first core pillar and a second core pillar, and the first core pillar and the second core pillar respectively penetrate a first through hole and a second through hole of the circuit board. The primary-side trace surrounds the first through hole in a first direction and surrounds the second through hole in a second direction to form an ∞-shaped trace. The inductor trace is formed on the primary-side layer board and coupled to the primary-side trace, and two ends of the inductor trace form an input terminal and an output terminal of the planar magnetic component.

The main purpose and effect of the present disclosure is that the planar magnetic component is applied to the resonant converter so that the primary-side coil and the secondary-side coil are formed on the circuit board in the form of traces. Therefore, the planar magnetic component can be planarized to significantly increase the space utilization of the resonant converter achieve high power density requirements. In addition, the resonant converter also has a small size due to the use of a planar transformer, which can significantly increase the operating frequency of the resonant converter so that the isolated converter has the advantages of higher efficiency, significantly reduced power switch size, lighter weight and increased heat dissipation performance.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a circuit block diagram of a resonant converter of the present disclosure.
FIG. 2A is an exploded perspective view of the resonant converter of the present disclosure.
FIG. 2B is an assembly perspective view of the resonant converter of the present disclosure.
FIG. 3A to FIG. 3L are schematic diagrams of the wiring of the coil of the planar magnetic component on each layer of a circuit board of the present disclosure.
FIG. 3M is a schematic diagram of ∞-shaped trace of the coil of the planar magnetic component according to the present disclosure.
FIG. 4A is a current path diagram of the resonant converter when a first rectification switch is turned on according to the present disclosure.
FIG. 4B is a current path diagram of a primary-side trace when the first rectification switch is turned on according to the present disclosure.
FIG. 4C is a current path diagram of a secondary-side trace when the first rectification switch is turned on according to the present disclosure.
FIG. 5A is a current path diagram of the resonant converter when a second rectification switch is turned on according to the present disclosure.
FIG. 5B is a current path diagram of the primary-side trace when the second rectification switch is turned on according to the present disclosure.
FIG. 5C is a current path diagram of the secondary-side trace when the second rectification switch is turned on according to the present disclosure.
FIG. 6 is a schematic structural diagram of the inductor core and the first core with the first through hole, the second through hole and the third through hole of the present disclosure.

### DETAILED DESCRIPTION

Reference will now be made to the drawing figures to describe the present disclosure in detail. It will be understood that the drawing figures and exemplified embodiments of present disclosure are not limited to the details thereof.

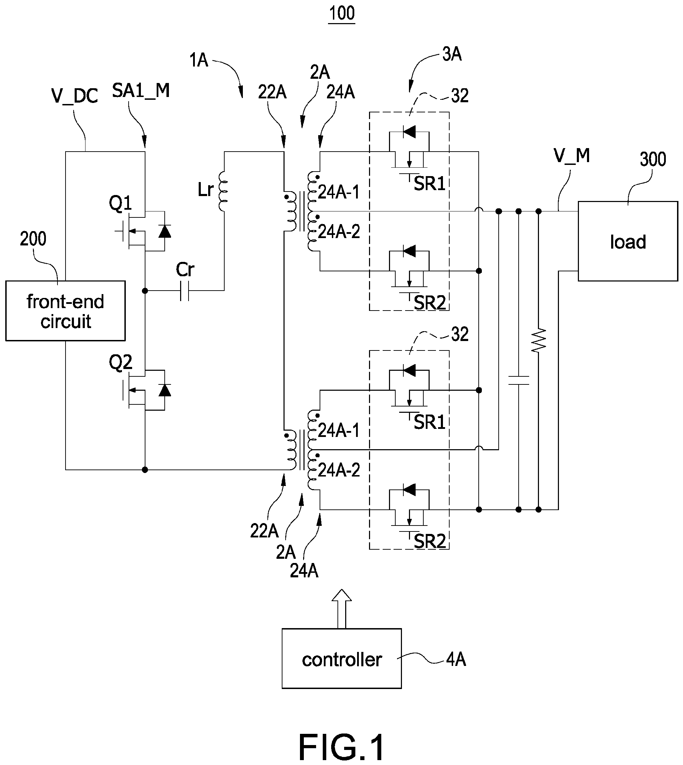

Please refer to FIG. 1, which shows a circuit block diagram of a resonant converter of the present disclosure. The resonant converter 100 is be coupled to a front-end circuit 200 and a load 300, and the front-end circuit 200 may be a DC power supply such as an AC-to-DC converter, a power factor corrector, a DC power source, or so on. The resonant converter 100 includes a primary-side circuit 1A, at least one transformer 2A (two transformers are shown as an example), at least one secondary-side circuit 3A (two secondary-side circuits are shown as an example), and a controller 4A. The transformer 2A includes a primary-side coil 22A and a secondary-side coil 24A. Taking FIG. 1 as an example, the primary-side circuit 1A is a half-bridge architecture, including one switch bridge arm SA1_M and one resonant tank (i.e., a resonant inductor Lr and a resonant capacitor Cr), and the switch bridge arm SA1_M includes two power switches Q1,Q2 connected in series. The secondary-side circuit 3A includes two rectification circuits 32, and each rectification circuit 32 includes two rectification switches SR1,SR2. The secondary-side coil 24A of the transformer 2A includes a first winding 24A-1 and a second winding 24A-2, and the first winding 24A-1 and the second winding 24A-2 are center-tapped windings. Therefore, the resonant converter 100 can control the turning on/turning off of the rectification switches SR1,SR2 by the controller 4A, so that the first winding 24A-1 and the second winding 24A-2 are respectively coupled to the primary-side coil 22A.

In general, the controller 4A controls the switch bridge arm SA1_M and the rectification switches SR1,SR2 of the rectification circuit 32 to operate the resonant tank and the transformer 2A storing energy and releasing energy so as to convert the DC power source V_DC received by the resonant converter 100 into a main power source V_M. Incidentally, the circuit structures of the primary-side circuit 1A and the secondary-side circuit 3A are only illustrative examples. As long as the primary-side circuit 1A (such as, but not limited to, a full-bridge structure, two resonant tanks, etc.) and the secondary-side circuit 3A (such as, but not limited to, a half-bridge rectification circuit, one rectification circuit, etc.) can form the structure of the resonant converter 100, should be included in the scope of this embodiment. In one embodiment, the number of the transformers 2A is not limited to two as shown in FIG. 1, i.e., the number of the transformer 2A may be one or more than one. When the number of the transformer 2Ais one, the resonant converter 100 includes one primary-side coil 22A, one first winding 24A-1, and one second winding 24A-2, and so on.

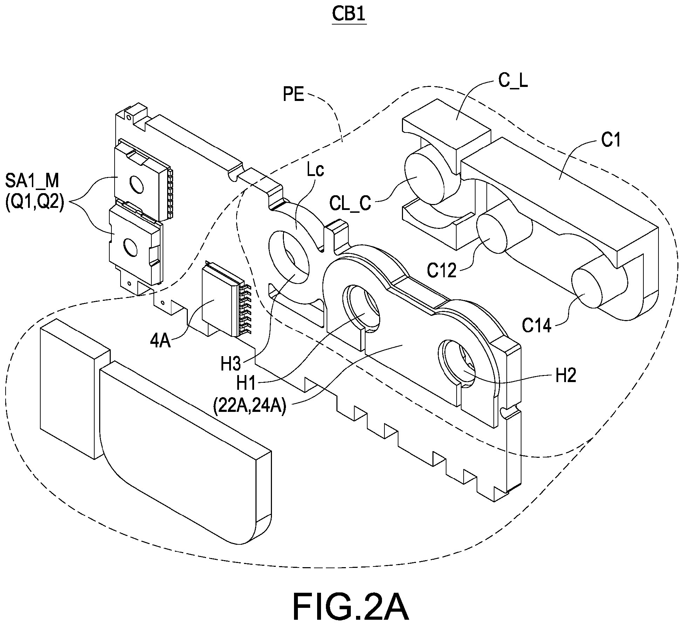

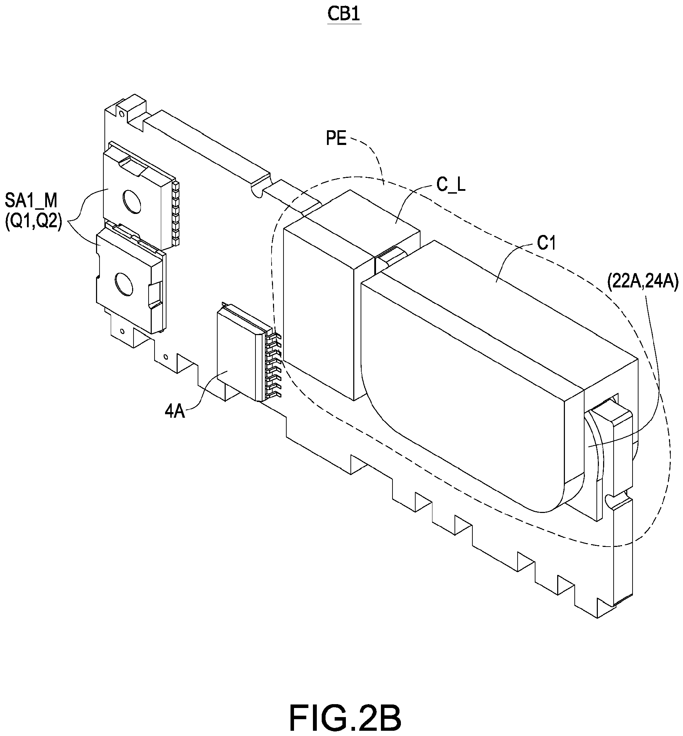

Please refer to FIG. 2A, which shows an exploded perspective view of the resonant converter of the present disclosure; please refer to FIG. 2B, which shows an assembly perspective view of the resonant converter of the present disclosure, and also refer to FIG. 1. The circuit components of the resonant converter 100 are configured on a circuit board CB1, and the two switch bridge arms SA1_M and the controller 4Aare arranged in positions as shown in FIG. 1. In particular, the resonant inductor Lr and the (at least one) transformer 2A form a planar magnetic component PE. Specifically, an inductor coil Lc of the resonant inductor Lr and the primary-side coil 22A and the secondary-side coil 24A of the transformer 2A are all planar structures, which are formed on the circuit board CB1. An iron core C1 is directly sleeved on the primary-side coil 22A and the secondary-side coil 24A of the circuit board CB1 to form the (at least one) transformer 2A, and an inductor iron core C_L is directly sleeved on an inductor coil Lc of the circuit board CB1 to form the resonant inductor Lr.

Therefore, the structure of the resonant converter 100 of the present disclosure mainly forms the inductor coil Lc of the resonant inductor Lr and the primary-side coil 22A and the secondary-side coil 24A of the transformer 2A on the circuit board CB1, so that the planar magnetic component PE can be planarized to significantly increase the space utilization of the resonant converter 100 and meet the requirement of the high power density. In addition, due to the small size of the planar magnetic component PE, the operating frequency of the resonant converter 100 can be significantly increased. Therefore, the power switches of the switch bridge arm SA1_M and the rectification circuit 32 can use third-generation semiconductor components such as the wide bandgap (WBG) as the main power switch, so that the resonant converter 100 has the advantages of higher efficiency, significantly reduced power switch size, lighter weight, and increased heat dissipation performance.

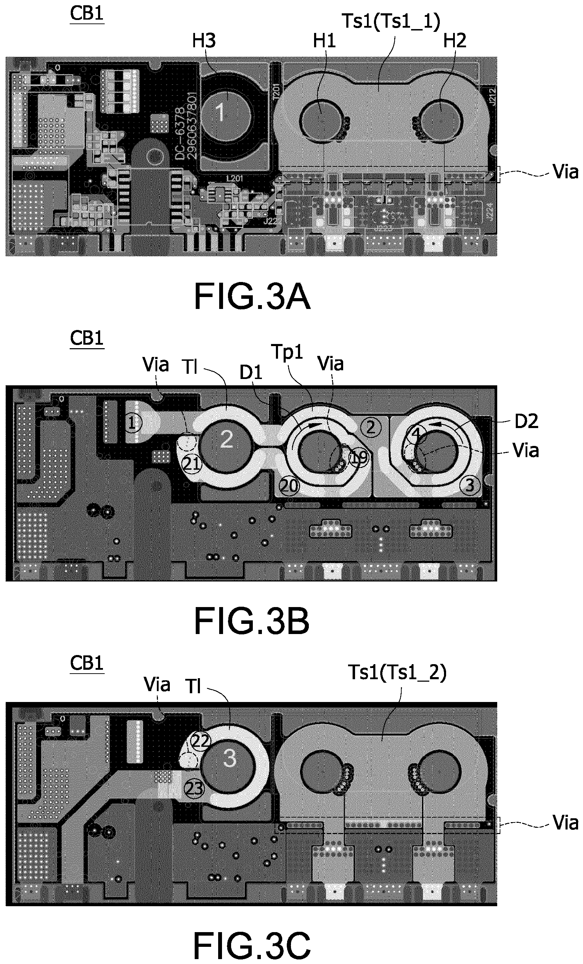

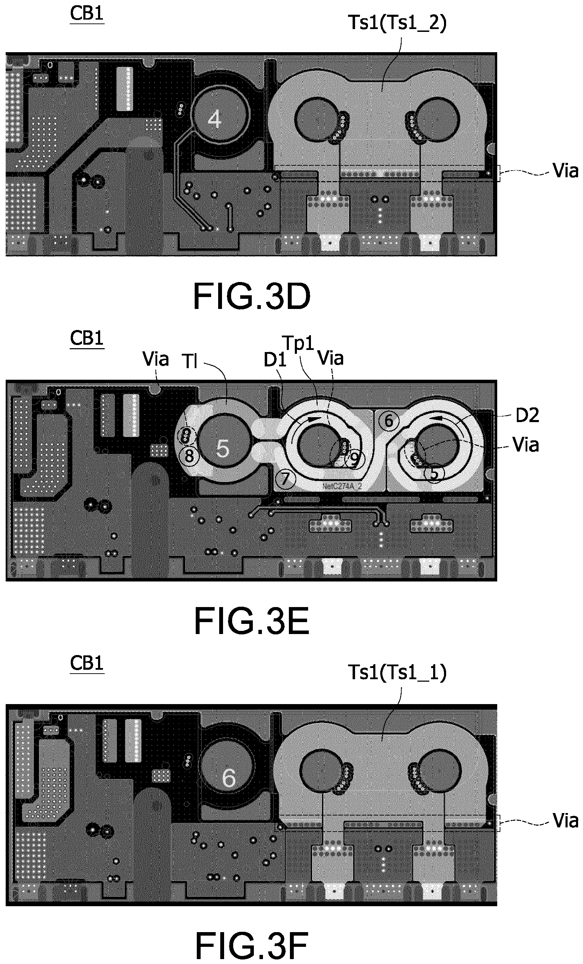

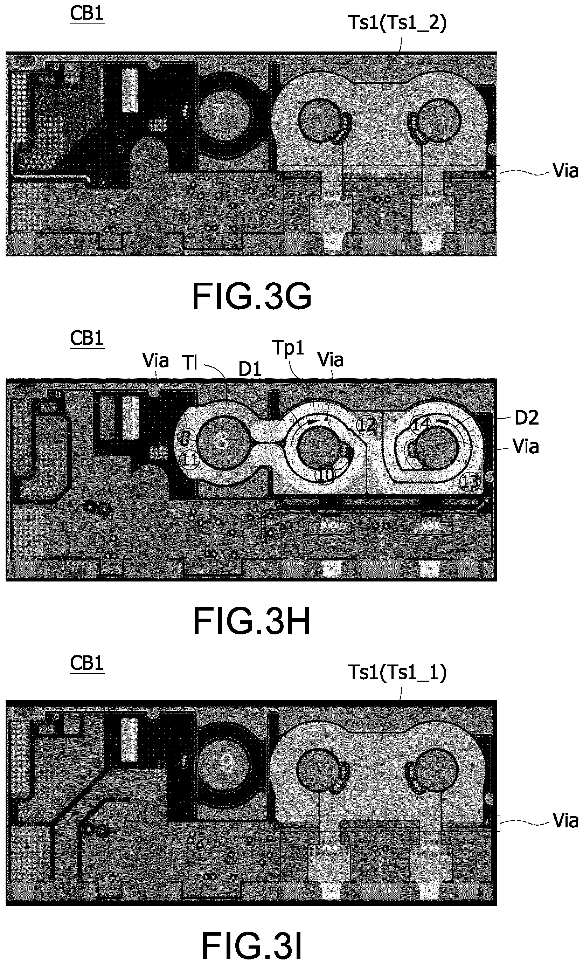

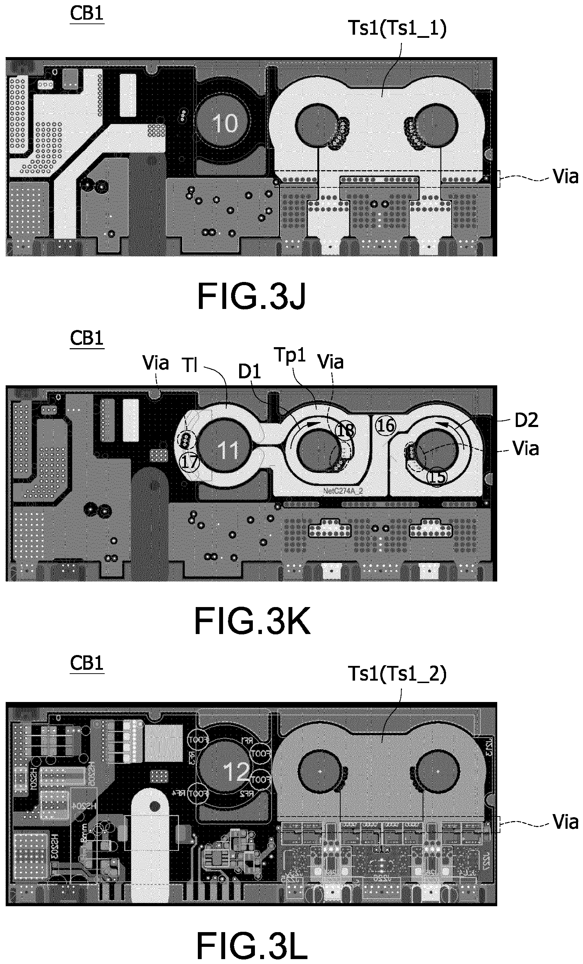

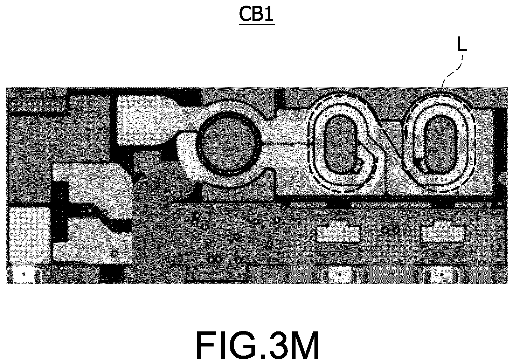

Please refer to FIG. 3A to FIG. 3L, which show schematic diagrams of the wiring of the coil of the planar magnetic component on each layer of a circuit board of the present disclosure; please refer to FIG. 3M, which shows a schematic diagram of ∞-shaped trace of the coil of the planar magnetic component according to the present disclosure, and also refer to FIG. 1 to FIG. 2B. The circuit board CB1 is a multi-layer board (a 12-layer board is used as an example, but is not limited thereto), and FIG. 3A shows the top board, and FIG. 3L shows the bottom board. In particular, an inductor trace Tl serves as the inductor coil Lc, and a primary-side trace Tp1 serves as the primary-side coil 22A. The inductor trace Tl and the primary-side trace Tp1 are respectively formed on layer boards of FIG. 3B, FIG. 3E, FIG. 3H, and FIG. 3K (i.e., referred to as primary-side layer boards). That is, the inductor traces Tl of each layer are connected to each other to form the inductor coil Lc, and the primary-side traces Tp1 of each layer are connected to each other to form the primary-side coil 22A. The secondary-side traces Ts1 are formed on layer boards of FIG. 3A, FIG. 3C, FIG. 3D, FIG. 3F, FIG. 3G, FIG. 3I, FIG. 3J, and FIG. 3L (i.e., referred to as secondary-side layer boards).

Please refer to FIG. 2A and FIG. 2B, the iron core C1 includes a first core pillar C12 and a second core pillar C14. The first core pillar C12 penetrates a first through hole H1 of the circuit board CB1, and the second core pillar C14 penetrates a second through hole H2 of the circuit board CB1. The primary-side traces Tp1 surround the first through hole H1 and the second through hole H2, and the secondary-side traces Ts1 also surround the first through hole H1 and the second through hole H2, so that after the iron core C1 is sleeved on the primary-side traces Tp1 and the secondary-side traces Ts1, closed magnetic paths can be formed in the transformer 2A. Similarly, the inductor iron core C_L includes a core pillar C_LC. The core pillar C_LC penetrates a third through hole H3 of the circuit board CB1. The inductor traces Tl surround the third through hole H3, so that after the inductor iron core C_L is sleeved on the inductor traces Tl, closed magnetic paths can be formed in the resonant inductor Lr. In particular, the material of the traces formed by each layer board may be copper foil, but it does not exclude the use of other metal foils that are easy to conduct electricity (such as, but not limited to, gold, silver, etc.).

In FIG. 3B, FIG. 3E, FIG. 3H, and FIG. 3K, the primary-side traces Tp1 surround the first through hole H1 in a first direction D1 (clockwise direction/counterclockwise direction), and surround the second through hole H2 in a second direction D2 (counterclockwise direction/clockwise direction) opposite to the first direction D1 to form co-shaped traces. That is, when the primary-side traces Tp1 surround the first through hole H1 in the clockwise direction, they will surround the second through hole H2 in the counterclockwise direction. On the contrary, when the primary-side traces Tp1 surround the first through hole H1 in the counterclockwise direction, they will surround the second through hole H2 in the clockwise direction. In one embodiment, the primary-side traces Tp1 shown in FIG. 3B, FIG. 3E, FIG. 3H, and FIG. 3K form two primary-side coils 22A as shown in FIG. 1. It can be inferred similarly that depending on the circuit configuration of the resonant converter 100, the primary-side traces Tp1 may form one or more than one primary-side coils 22A. The number of the primary-side coils 22A may be added depending on the number of layers of the circuit board CB1 and the number of turns of the primary-side traces Tp1, which will not be described again here.

In particular, a plurality of via holes via are formed on one side of the first through hole H1 and the second through hole H2 respectively. These via holes via are filled with conductive materials (such as, but not limited to, solder paste and other conductive materials), so that the primary-side traces Tp1 of the primary-side layer boards in FIG. 3B, FIG. 3E, FIG. 3H, and FIG. 3K can be electrically connected to each other through the via holes via. That is, the primary-side traces Tp1 of the primary-side layer boards in FIG. 3B, FIG. 3E, FIG. 3H, and FIG. 3K are connected in series through the via holes via to form the primary-side coils 22A.

Specifically, in FIG. 3B, FIG. 3C, FIG. 3E, FIG. 3H, and FIG. 3K, numbers 1 to 23 are marked respectively. The sequence of numbers increasing from 1 to 23 corresponds to the path of the primary-side current flowing from the inductor traces Tl to the resonant capacitor Cr, and at the terminal of the traces, it will be connected to the traces on another layer through the via holes via. On the contrary, if the primary-side current flows through the path from the resonant capacitor Cr to the inductor traces T1, the number will decrease from 23 to 1. In particular, the inductor traces T1 on the second layer board and the third layer board of FIG. 3B and FIG. 3C respectively form the input terminal (position marked 1) and the output terminal (position marked 23) of the planar magnetic component PE. Therefore, it can be clearly seen that on adjacent primary-side layer boards (for example, but not limited to, FIG. 3B and FIG. 3E), the surrounding direction of the primary-side traces Tp1 will be the same (referring to the flow direction of the primary-side current). For example, in FIG. 3B, taking the condition that the first rectification switch SR1 is turned on as an example, the primary-side traces Tp1 start from the first through hole H1 in a clockwise direction (i.e., the first direction D1), and approach the second through hole H2 in a counterclockwise direction (i.e., the second direction D2). Similarly, the current path adjacent to the primary-side traces Tp1 (FIG. 3E) is opposite, that is, the primary-side traces Tp1 approach the first through hole H1 in the clockwise direction (i.e., the first direction D1), and start from the second through hole H2 in the counterclockwise direction (i.e., the second direction D2). The rest may be deduced by analogy, and no further details will be given.

In FIG. 3B, when the second rectification switch SR2 is turned on, the situation is exactly the opposite, that is, the primary-side traces Tp1 start from the first through hole H1 in the counterclockwise direction (i.e., the first direction D1), and approach the second through hole H2 in the clockwise direction (i.e., the second direction D2). The rest may be deduced by analogy, and no further details will be given. The first direction D1 and the second direction D2 refer to the current directions surrounding the first through hole H1 and the second through hole H2 as two different current directions, and are not limited to a clockwise direction or a counterclockwise direction. Therefore, the primary-side traces Tp1 surround the first through-hole H1 and the second through-hole H2 for at least two turns respectively, and similarly forms an co-shaped pattern (as shown by the line L in FIG. 3M), which is referred to as an ∞-character trace.

On the other hand, the primary-side traces Tp1 of the present disclosure further integrates the inductor traces Tl, and the inductor traces Tl surround the third through hole H3. Furthermore, as shown in FIG. 1, although the resonant inductor Lr is a different circuit component from the transformer 2A, in fact the two can be configured separately (that is, the two may include other circuit components, such as but not limited to, the resonant capacitor Cr), the circuit components of the two are similar in type and will also have a coil structure. Therefore, in the present disclosure, it is a preferred embodiment to integrate the inductor coil Lc of the resonant inductor Lr and the primary-side coils 22A to form the planar magnetic component PE, but it is not limited to this in practice. On the other hand, the iron core C1 and the inductor iron core C_L can also be configured separately, so that the height of the core pillar C_LC of the inductor iron core C_L can be easily processed (adjusting the air gap) and its parameters can be controlled relatively accurately. The separate configuration also allows the iron core C1 and the inductor iron core C_L to easily adjust their own parameters (such as but not limited to, inductance value, etc.). Alternatively, the iron core C1 and the inductor iron core C_L can be integrated into an integrated magnetic component.

Specifically, the metal foil of the inductor trace Tl of the present disclosure is directly connected to the metal foil of the primary-side trace Tp1 to form a common trace structure. A plurality of via holes via are also formed on one side of the third through hole H3, and these via holes via are also filled with conductive materials so that the primary-side traces Tp1 and the inductor traces Tl of the primary-side layer boards in FIG. 3B, FIG. 3E, FIG. 3H, and FIG. 3K can be electrically connected through the via holes via. That is, the primary-side traces Tp1 and the inductor traces Tl of the primary-side layer boards in FIG. 3B, FIG. 3E, FIG. 3H, and FIG. 3K are connected in series through the via holes via respectively, and by sleeving the iron core C1 on the inductor iron core C_L, the primary-side coil 22A and the inductor iron core C_L can be respectively formed. In other words, the entire metal foil in FIG. 3B, FIG. 3E, FIG. 3H, and FIG. 3K is an integrally formed structure, and part of the integrally formed metal foil belongs to the inductor trace Tl, and the other part of the integrally formed metal foil belongs to the primary-side trace Tp1.

On the other hand, in FIG. 3B, FIG. 3E, FIG. 3H, and FIG. 3K, although the metal foils of the inductor trace Tl and the primary-side trace Tp1 are located on the same layer and they are an integrally formed structure, the inductor trace Tl and the primary-side trace Tp1 can also be on different layers and coupled through via holes via. Therefore, the metal foil of the inductor trace T1 can be coupled to the primary-side trace Tp1 through coupling manner to form the same path. For example, but not limited to the via holes via, or other circuit components such as the resonant capacitor Cr between the two. Therefore, although the metal foil of the inductor trace T1 and the primary-side trace Tp1 is an integrally formed structure as shown in FIG. 3B, FIG. 3E, FIG. 3H, and FIG. 3K, the inductor trace Tl and the metal foil of the primary-side trace Tp1 can be configured separately, that is, the inductor trace Tl and the metal foil of the primary-side trace Tp1 in FIG. 3B, FIG. 3E, FIG. 3H, and FIG. 3K are disconnected, and coupled through via holes via or other circuit components that can be connected in series on this path.

In one embodiment, although the inductor trace Tl and the primary-side trace Tp1 can be directly connected by their trace sides (in the co-shaped traces), the preferred implementation is as shown in FIG. 3E, FIG. 3H, and FIG. 3K where the primary-side trace Tp1 and the inductor trace Tl form a single path. In particular, although the inductor trace Tl in FIG. 3B is interrupted, it is actually coupled to the switch bridge arm SA1_M or the resonant capacitor Cr according to different circuit configurations of the circuit board CB1 as shown in FIG. 1. Therefore, in addition to being coupled to other circuit components, the inductor trace T1 will not be interrupted and can form a single path. That is, as shown in FIG. 2A, FIG. 23B, and FIG. 3A to FIG. 3M, the input terminal and the output terminal of the entire planar magnetic component PE are formed on a layer equipped with the inductor trace T1, and the two ends of the inductor trace Tl (see FIG. 3C) form the input terminal and the output terminal of the planar magnetic component PE, so that a structure is formed in which the planar magnetic component PE is connected in parallel to the power switch Q2 (taking the circuit structure of FIG. 2A as an example). Therefore, in the present disclosure, the primary-side trace Tp1 uses the ∞-shaped trace design, and the inductor trace Tl of the resonant inductor Lr is integrated to form a large-area metal foil that integrates circuit components into one. Therefore, the magnetic fluxes of the iron core C1 (the same as the inductor iron core C_L) can cancel each other out, so that in addition to reducing the DC contact loss, significantly reducing the loss caused by the AC eddy current, and reducing the loss of the iron core C1 (the inductor iron core C_L).

On the other hand, as shown in FIG. 3C, in addition to being disposed on the primary-side layer board (that is, the layer boards in FIG. 3B, FIG. 3E, FIG. 3H, and FIG. 3K), the inductor trace T1 can also be disposed on the secondary-side layer board. The main reason is that the inductance value of the inductor trace Tl can be adjusted by adjusting the number of layers of the inductor trace Tl. Therefore, the inductor trace T1 can be configured on any layer board of the primary-side layer boards and the secondary-side layer boards, and is not limited to being configured only on the primary-side layer boards of FIG. 3B, FIG. 3E, FIG. 3H, and FIG. 3K.

In addition, due to the design of the primary-side trace Tp1 and the inductor trace Tl, the number of via holes via on the circuit board CB1 can be reduced to connect each primary-side layer board. Specifically, as shown in FIG. 3B, FIG. 3E, FIG. 3H, and FIG. 3K, six via holes via are respectively included on one side of the first through hole H1 and the second through hole H2, i.e., the total number is 12. Through these via holes via, the primary-side traces Tp1 in FIG. 3B, FIG. 3E, FIG. 3H, and FIG. 3K with different trace directions (i.e., the first direction D1 and the second direction D2) can be connected in series. On the other hand, the primary-side trace Tp1 can pass through the three via holes via that integrate with the inductor trace Tl, so that the inductor traces Tl in FIG. 3B, FIG. 3E, FIG. 3H, and FIG. 3K can be connected in series. Therefore, the number of via holes via used to connect each primary-side layer board can be limited to less than or equal to 15.

Please refer to the secondary-side layer boards shown in FIG. 3A, FIG. 3C, FIG. 3D, FIG. 3F, FIG. 3G, FIG. 3I, FIG. 3L, and FIG. 3L, and also refer to FIG. 1. Since the secondary-side coil 24A has a center-tapped winding structure, in FIG. 3A, FIG. 3C, FIG. 3D, FIG. 3F, FIG. 3G, FIG. 3I, FIG. 3J, and FIG. 3L, the secondary-side trace Ts1 and the first through hole H1 and the second through hole H2 form an m-shaped trace. Moreover, the current flowing through the secondary-side trace Ts1 can flow out from the center point of the m-shape trace to two terminals respectively, or flow from the two terminals of the m-shape trace to the center point according to the actions of the rectification switches SR1,SR2, there will be further explanations later. The bottom of m-shape trace may include a plurality of via holes via. These via holes via are filled with conductive material inside, so that the secondary-side traces Ts1 of the secondary-side layer boards in FIG. 3A, FIG. 3C, FIG. 3D, FIG. 3F, FIG. 3G, FIG. 3I, FIG. 3J, and FIG. 3L can be electrically connected to each other through the via holes via. In particular, the secondary-side traces Ts1 of the secondary-side layer boards in FIG. 3A, FIG. 3F, FIG. 3I, and FIG. 3J can be connected through via holes via respectively to form two first coils 24A-1 (as shown in FIG. 1). The secondary-side traces Ts1 of the secondary-side layer boards in FIG. 3C, FIG. 3D, FIG. 3G, and FIG. 3L can be connected through via holes via respectively to form two second coils 24A-2 (as shown in FIG. 1). Similarly, the secondary-side traces Ts1 shown in FIG. 3A, FIG. 3C, FIG. 3D, FIG. 3F, FIG. 3G, FIG. 3I, FIG. 3J, and FIG. 3L can form two secondary-side coils 24A as shown in FIG. 1. It can be inferred similarly that depending on the circuit configuration of the resonant converter 100, the secondary-side traces Ts1 may form one or more than one secondary-side coils 24A. The number of the secondary-side coils 24A may be added depending on the number of layers of the circuit board CB1 and the number of turns of the secondary-side traces Ts1, which will not be described again here.

In addition, the circuit board CB1 of the present disclosure has a trace structure that forms the inductor trace T1, the primary-side trace Tp1, and the secondary-side trace Ts1, and its preferred number of layers may be three or more. In particular, one layer forms the inductor trace Tl and the primary-side trace Tp1, and the other two layers form the first trace Ts1_1 and the second trace Ts1_2 respectively. The two layers (the first trace Ts1_1 and the second trace Ts1_2) can also form an additional inductor trace T 1, or the inductor trace T1 can also be formed on an independent layer board. That is, the inductor trace Tl may be independently configured on a layer without the primary-side trace Tp1 and the secondary-side trace Ts1. For example, in one embodiment, the circuit board CB1 may only be composed of the layer boards in FIG. 3A to FIG. 3C, or the circuit board CB1 may be composed of the layer boards in FIG. 3A to FIG. 3F. The rest may be deduced by analogy, and no further details will be given.

Please refer to FIG. 2A and FIG. 2B, the inductor iron core C_L may include an air gap (not shown). Since the number of layers of the inductor trace Tl is a specific number, the inductance value of the resonant inductor Lr can be controlled by adjusting the air gap of the inductor iron core C_L. On the other hand, since the resonant inductor Lr is separated from the iron core C1 of the transformer 2A, the air gap of the inductor iron core C_L can be accurately controlled. In particular, the air gap of the inductor iron core C_L may usually be formed in the core pillar C_LC, but is not limited to this. Any position where the inductance value of the resonant inductor Lr can be adjusted is formed and should be included in the scope of this embodiment. In addition, the iron core C1 may also include an air gap (not shown) to increase the magnetic resistance of the transformer 2A and reduce the probability of magnetic saturation of the transformer 2A. A similar air gap of the iron core C1 can usually be formed in the first core pillar C12 and/or the second core pillar C14, but is not limited thereto. Any formation position that can increase the magnetic resistance of the transformer 2A should be included in the scope of this embodiment. In addition, the size of air gap of the inductor iron core C_L and the iron core C1 may be different to meet the needs of individual parameter adjustment.

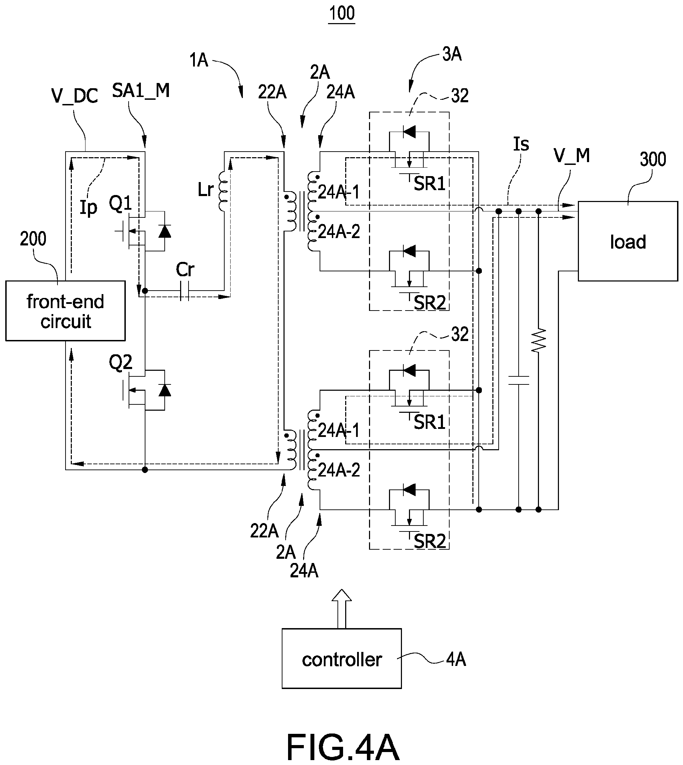

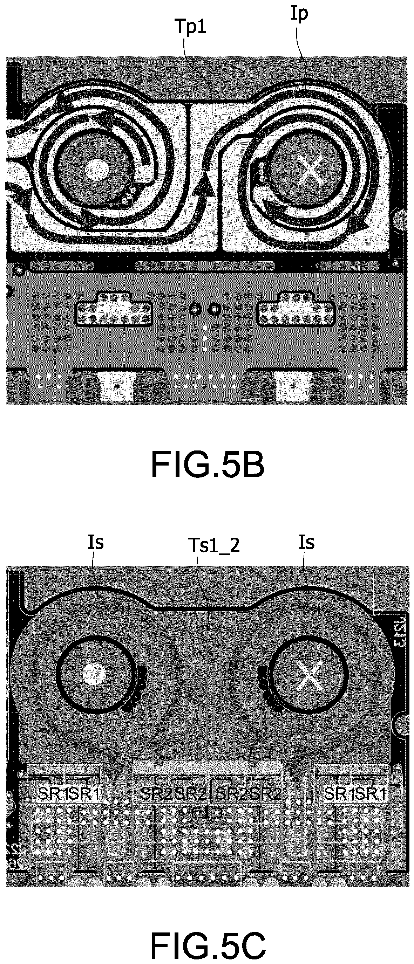

Please refer to FIG. 4A, which shows a current path diagram of the resonant converter when a first rectification switch is turned on according to the present disclosure; please refer to FIG. 5B, which shows a current path diagram of a primary-side trace when the first rectification switch is turned on according to the present disclosure; please refer to FIG. 5C, which shows a current path diagram of a secondary-side trace when the first rectification switch is turned on according to the present disclosure, and also refer to FIG. 1 to FIG. 3M. In FIG. 4A, when the controller 4A controls the first power switch Q1 to be turned on, the primary-side current Ip flows through the path of the first power switch Q1 and the primary-side coil 22A. In this condition, the controller 4A also controls the first rectification switch SR1 to be turned on to generate a path for the secondary-side current Is to flow from the first trace Ts1_1 (i.e., the first coil 24A-1) to the output terminal of the resonant converter 100. Since the first coil 24A-1 and the second coil 24A-2 are center-tapped coils, and only the first rectification switch SR1 or the second rectification switch SR2 operates in the same half cycle, the second rectification switch SR2 is not turned on and does not form a path from the second trace Ts1_2 (i.e., the second coil 24A-2) to the output terminal of the resonant converter 100.

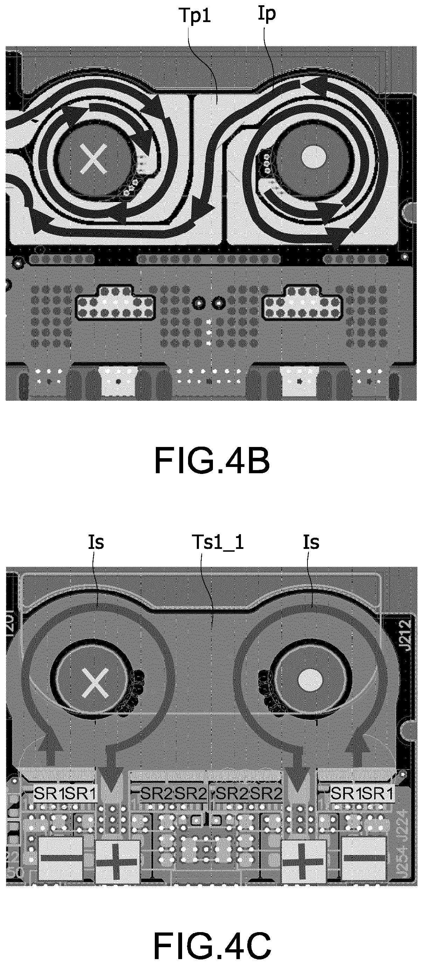

Please refer to FIG. 4B, since the traces surrounding the first through hole H1 are exactly opposite to the traces surrounding the second through hole H2, the current direction of the primary-side current Ip is also opposite so that the polarity of the first core pillar C12 and the second core pillar C14 are reversed (indicated by a dot and a mark X). Please refer to FIG. 4C, since the first rectification switch SR1 and the second rectification switch SR2 must be arranged on the surface layer of the circuit board CB1 (i.e., the top layer of FIG. 3A or the bottom layer of FIG. 3L), when the first rectification switches SR1 and the second rectification switches SR2 of the two secondary-side circuits 3A operate, they have a parallel structure. Therefore, the current direction of the secondary-side current Is is the same as the direction of the primary-side current Ip, so that the polarity of the first core pillar C12 and the polarity of the second core pillar C14 are also opposite, and the primary-side current Ip and the secondary-side current Is make the polarity formed by the first core pillar C12 be the same (the same is true for the second core pillar C14).

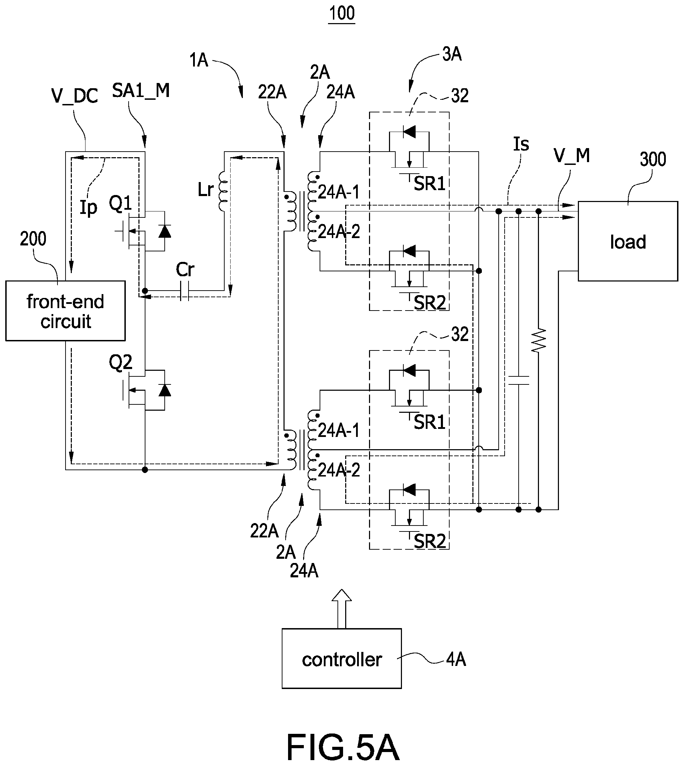

Please refer to FIG. 5A, which shows a current path diagram of the resonant converter when a second rectification switch is turned on according to the present disclosure; please refer to FIG. 5B, which shows a current path diagram of the primary-side trace when the second rectification switch is turned on according to the present disclosure; please refer to FIG. 5C, which shows a current path diagram of the secondary-side trace when the second rectification switch is turned on according to the present disclosure, and also refer to FIG. 1 to FIG. 4C. The difference between FIG. 5A to FIG. 5C and FIG. 4A to FIG. 4C is that the controller 4A controls the second power switch Q2 to be turned on, and controls the first rectification switch SR1 to be turned off and the second rectification switch SR2 to be turned on. Therefore, the directions of the primary-side current Ip and the secondary-side current Is are exactly opposite to those shown in FIG. 4A to FIG. 4C, and the polarity of the first core pillar C12 and the polarity of the second core pillar C14 are also exactly opposite to those shown in FIG. 4A to FIG. 4C, which will not be described again here.

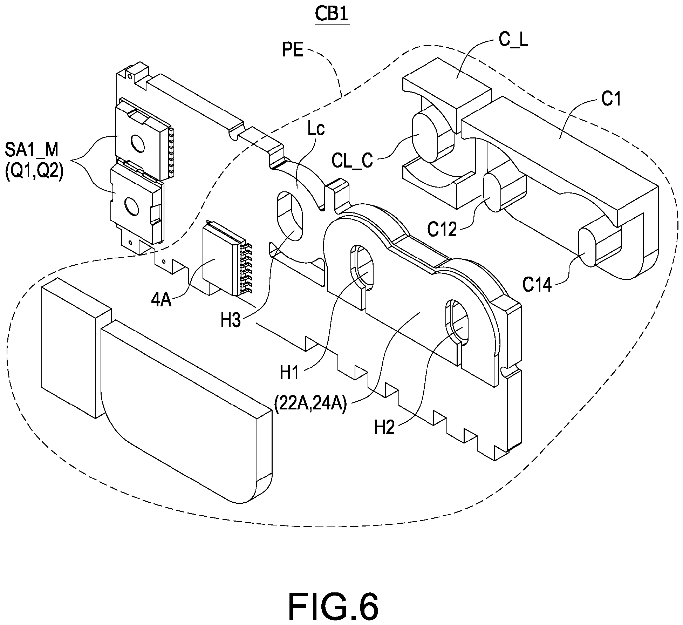

Please refer to FIG. 6, which shows a schematic structural diagram of the inductor core and the first core with the first through hole, the second through hole and the third through hole of the present disclosure, and also refer to FIG. 1 to FIG. 3L. In FIG. 2A to FIG. 3L, the first core pillar C12 and the second core pillar C14 of the transformer 2A may both be circular pillars. However, since the magnetic field lines must complete the circuit in the shortest path, the circular cylinder (circular pillar) structure will cause the magnetic field lines to gather at a circular point, which may cause uneven distribution of the magnetic field. Therefore, in FIG. 6, the cylinder shapes of the first core pillar C12 and the second core pillar C14 of the transformer 2A can be changed to elliptical cylinders with straight sides. Moreover, the hole shapes of the first through hole H1 and the second through hole H2 may also be elliptical through holes for the first core pillar C12 and the second core pillar C14 to penetrate. Furthermore, since the adjacent sides of the two core pillars C12,C14 are substantially parallel straight lines, the shortest distances between them are the same. That is, the cylinder shape of the first core pillar C12 and the cylinder shape of the second core pillar C14 are respectively elliptical cylinders, and the arcs of the two adjacent sides can be relatively gentle, or preferably can be parallel straight lines, thereby increasing the magnetic field distribution between traces and increasing efficiency. On the other hand, although not shown in FIG. 6, the core pillar C_LC of the inductor iron core C_L may also be an elliptical cylinder (elliptical pillar), and the hole shape of the third through hole H3 may also be an elliptical through hole.

## Claims

1. A planar magnetic component (PE) arranged on a circuit board (CB1) of a resonant converter (100), the resonant converter (100) comprising a primary-side circuit (1A) and a secondary-side circuit (3A), **characterized in that** the planar magnetic component (PE) comprising:
an inductor trace (Tl) arranged on the circuit board (CB1) to serve as an inductor coil (Lc) coupled to the primary-side circuit (1A),
a primary-side trace (Tp1) formed on one primary-side layer board of the circuit board (CB1) to serve as a primary-side coil (22A) coupled to the primary-side circuit (1A),
a secondary-side trace (Ts1) formed on one secondary-side layer board of the circuit board (CB1) to serve as a secondary-side coil (24A) coupled to the secondary-side circuit (3A), and
an iron core assembly comprising:
an inductor iron core (C_L) comprising a core pillar (C_LC), the core pillar (C_LC) penetrating a third through hole (H3) of the circuit board (CB1) and the inductor trace (Tl) surrounding the third through hole (H3), and
an iron core (C1) comprising a first core pillar (C12) and a second core pillar (C14), the first core pillar (C12) and the second core pillar (C14) respectively penetrating a first through hole (H1) and a second through hole (H2) of the circuit board (CB1),
wherein the primary-side trace (Tp1) surrounds the first through hole (H1) in a first direction (D1) and surrounds the second through hole (H2) in a second direction (D2) to form an oo-shaped trace (L),
wherein the inductor trace (Tl) is formed on the primary-side layer board and coupled to the primary-side trace (Tp1), and two ends of the inductor trace (Tl) form an input terminal and an output terminal of the planar magnetic component (PE).

2. The planar magnetic component (PE) as claimed in claim 1, wherein the primary-side trace (Tp1) surrounds the first through hole (H1) and the second through hole (H2) for at least two turns respectively.

3. The planar magnetic component (PE) as claimed in claim 1, wherein the circuit board (CB1) is a multi-layer board, and comprises the primary-side layer board and at least two secondary-side layer boards; the number of the secondary-side traces (Ts1) is plural, and the secondary-side traces (Ts1) respectively arranged on the at least two secondary-side layer boards,
wherein the secondary-side traces (Ts1) comprise a first trace (Ts1_1) and a second trace (Ts1_2), and the first trace (Ts1_1) and the second trace (Ts1_2) are respectively formed on the at least two secondary-side layer boards.

4. The planar magnetic component (PE) as claimed in claim 3, wherein the secondary-side circuit (3A) comprises two rectification circuits (32), and each rectification circuit (32) comprises a rectification switch; the iron core (C1) is sleeved on the first trace (Ts1_1) and the second trace (Ts1_2) to form the secondary-side coil (24A) of a transformer (2A) with a center-tapped structure, and the secondary-side coil (24A) is coupled to the two rectification circuits (32) to form a secondary-side topology,
wherein the rectification switches of the two rectification circuits (32) are respectively arranged on a top layer and a bottom layer of the circuit board (CB1).

5. The planar magnetic component (PE) as claimed in claim 3, wherein the number of the inductor traces (Tl) is plural, and one of the inductor traces (Tl) is independently formed on a layer board other than the primary-side layer board and the at least two secondary-side layer boards.

6. The planar magnetic component (PE) as claimed in claim 3, wherein the number of the inductor traces (Tl) is plural, and one of the inductor traces (Tl) is formed on one of the at least two secondary-side layer boards.

7. The planar magnetic component (PE) as claimed in claim 3, wherein the number of the inductor traces (Tl) is plural, and one of the inductor traces (Tl) forms the input terminal, and one of the inductor traces (Tl) or another one of the inductor traces (Tl) forms the output terminal.

8. The planar magnetic component (PE) as claimed in claim 3, wherein the number of the inductor traces (Tl) is plural, one terminals of the first through hole (H1), the second through hole (H2), and the third through hole (H3) are respectively formed on a plurality of via holes (via) filled with a conductive material, and the inductor traces (Tl) and the primary-side traces (Tp1) are electrically connected through the via holes (via),
wherein the number of via holes (via) on one side of the first through hole (H1) and the second through hole (H2) is less than or equal to 12, and the number of via holes (via) on one side of the third through hole (H3) is less than or equal to 3.

9. The planar magnetic component (PE) as claimed in claim 1, wherein the secondary-side trace (Ts1), the first through hole (H1), and the second through hole (H2) form an m-shaped trace.

10. The planar magnetic component (PE) as claimed in claim 1, wherein the primary-side trace (Tp1) and the inductor trace (Tl) form a single path.

11. The planar magnetic component (PE) as claimed in claim 1, wherein a metal foil of the inductor trace (Tl) and a metal foil of the primary-side trace (Tp1) have an integrally formed structure.

12. The planar magnetic component (PE) as claimed in claim 1, wherein the inductor iron core (C_L) is separated from the iron core (C1); the inductor iron core (C_L) comprises an air gap and the iron core (C1) comprises an air gap, and the air gap of the inductor iron core (C_L) and the air gap of the iron core (C1) are different in size.

13. The planar magnetic component (PE) as claimed in claim 1, wherein the primary-side circuit (1A) comprises a switch bridge arm (SA1_M) and a resonant tank, and the resonant tank comprises a resonant inductor (Lr) and a resonant capacitor (Cr) connected in series; the inductor iron core (C_L) is sleeved on the inductor trace (Tl) to form the resonant inductor (Lr), and the iron core (C1) is sleeved on the primary-side trace (Tp1) to form the primary-side coil (22A) of a transformer (2A), and the resonant tank couples the switch bridge arm (SA1_M) and the primary-side coil (22A) to form a primary-side topology.

14. The planar magnetic component (PE) as claimed in claim 1, wherein the circuit board (CB1) is a 12-layer board, and the number of the primary-side traces (Tp1) and the number of the secondary-side traces (Ts1) are both plural, and the secondary-side trace (Ts1) comprises first traces (Ts1_1) in a plurality of layers and second traces (Ts1_2) in a plurality of layers; the configuration from a top layer to a bottom layer of the circuit board (CB1) is sequentially the first trace (Ts1_1), the primary-side trace (Tp1), the second trace (Ts1_2), the second trace (Ts1_2), the primary-side trace (Tp1), the first trace (Ts1_1), the second trace (Ts1_2), the primary-side trace (Tp1), the first trace (Ts1_1), the first trace (Ts1_1), the primary-side trace (Tp1), and the second trace (Ts1_2).

15. The planar magnetic component (PE) as claimed in claim 14, wherein the number of the inductor traces (Tl) is plural, the inductor traces (Tl) are formed on the same layer as the primary-side traces (Tp1), and are formed on the same layer as the second traces (Ts1_2) on the third layer; the inductor traces (Tl) of the second layer and the third layer of the circuit board (CB1) form an input terminal and an output terminal respectively.
